# EUROPÄISCHE PATENTSCHRIFT

(11) **EP 2 845 305 B1**
(45) Veröffentlichungstag und Bekanntmachung des Hinweises auf die Patenterteilung: **14.10.2015**
(21) Anmeldenummer: 14734729.8
(22) Anmeldetag: 14.05.2014
(51) Int. Cl.: H02N 2/10, H02N 2/00, H01L 41/083, H02N 2/14

(54) **ULTRASCHALLMOTOR**
ULTRASONIC MOTOR
MOTEUR À ULTRASONS

(30) Priorität: 16.05.2013 DE 102013105024
(43) Veröffentlichungstag der Anmeldung: 11.03.2015
(73) Patentinhaber: Physik Instrumente (PI) GmbH & Co. KG, 76228 Karlsruhe (DE)
(72) Erfinder: WISCHNEWSKIY, Wladimir, 14712 Rathenow (DE); WISCHNEWSKI, Alexej, 76744 Wörth (DE)
(74) Vertreter: Schatt, Markus F.
(86) Internationale Anmeldenummer: PCT/DE2014/200215
(87) Internationale Veröffentlichungsnummer: WO 2014/183761

(56) Entgegenhaltungen:
- EP-A1- 0 536 832
- JP-A- 2010 028 955
- US-B2- 7 218 031

## Beschreibung

Die Erfindung betrifft einen Ultraschallmotor gemäß den Ansprüchen 1 bis 11.

Aus dem Stand der Technik gemäß den Druckschriften US 6,765,335 B1 oder US 7,218,031 B2 sind beispielsweise Ultraschallmotoren für einen Rotationsantrieb bekannt, bei welchen der Ultraschallaktor als piezoelektrischer Hohlzylinder ausgeführt ist und bei welchen Elektroden auf seinen Umfangsflächen und Friktionselemente auf seinen Stirnflächen angeordnet sind.

Bei diesen Ultraschallmotoren sind sowohl der Polarisationsvektor p, als auch der Vektor des elektrischen Erregerfeldes E radial und damit senkrecht zur axialen Richtung des piezoelektrischen Zylinders ausgerichtet. Daraus ergibt sich, dass die durch den Ultraschallaktor in axialer Richtung erzeugte dynamische Kraft Fad und die in tangentialer Richtung erzeugte dynamische Kraft Ftd durch den gleichen Piezomodul d31 bestimmt sind. In Grenzfällen können diese Kräfte gleich sein.

Das Antriebsprinzip dieser Ultraschallmotoren beruht auf der Übertragung der durch den Ultraschallaktor erzeugten Kraft an den Rotor über einen zwischen Ultraschallaktor und Rotor bestehenden Wirk- oder Reib- bzw. Friktionskontakt. Auf Grund dieses Antriebsprinzips muss die Reibungskraft Ffk hinsichtlich des Reibkontakts stets größer sein als die Amplitude der dynamischen Kraft Ftd. Trifft das nicht zu, resultiert ein ungewollter Schlupf zwischen Ultraschallaktor und Rotor, was zu einer verschlechterten oder sogar Fehl-Funktion des Ultraschallmotors führt.

Die Reibungskraft Ffk aufgrund des Friktionskontakts zwischen Ultraschallaktor und Rotor wird durch den Reibungskoeffizienten Kf der sich kontaktierenden Werkstoffe und der Anpresskraft Fa bestimmt. Für moderne harte, abriebfeste Werkstoffe beträgt dieser Koeffizient etwa 0,2-0,3 Für die Gewährleistung eines linearen Arbeitsbereich des Friktionskontaktes muss die Bedingung Ffk =Kf x Fa eigehalten werden. Das bedeutet, dass der Friktionskontakt des Ultraschallmotors die Reibungskraft Ffk aufweisen muss und dass das Friktionselement an die Friktionsoberfläche des Rotors mit einer Kraft Fa= Ffk/(0,2 bis 0.3) angepresst ist. Die Anpresskraft Fa muss daher etwa 3 - 5 Mal größer als die Amplitude der Kraft Ftd sein. Die Anpresskraft Fa setzt sich hierbei aus der statischen Anpresskraft Fas und der dynamischen Anpresskraft Fad zusammen, wobei die Kraft Fas durch eine Feder erzeugt wird. Für die optimale Funktion des Friktionskontakts muss die statische Anpresskraft Fas gleich der Amplitude der dynamischen Anpresskraft Fad sein.

Bei den aus dem Stand der Technik bekannten Ultraschallmotoren entwickelt der Aktor sowohl die in axialer Richtung wirkende Kraft Fad als auch die in tangentialer Richtung wirkende Kraft Ftd. Das ist damit erklärbar, dass beide Kräfte durch den gleichen Piezomodul d31 bestimmt sind. Deshalb kann in diesen Motoren die Amplitude der Anpresskraft Fa nur zweimal größer als die Amplitude der Kraft Ftd sein.

Daher ist auch die Reibungskraft Ffk im Friktionskontakt begrenzt und mit ihr die durch den Ultraschallmotor erzeugbare maximale Kraft, so dass es mit den aus dem Stand der Technik bekannten Ultraschallmotoren nicht möglich ist, die aufgrund der piezoelektrischen Parameter eigentlich erzielbaren maximalen Kräfte zu erzeugen.

Außerdem entstehen bei diesen Ultraschallmotoren unter hoher Last sehr große mechanische Verluste im Friktionskontakt (Schlupf).

Überdies erfordern derartige Motoren eine vergleichsweise hohe Erregerspannung, wodurch sich die Verluste in den Aktoren erhöhen.

All diese Effekte zusammen führen zu einer Erwärmung der Aktoren und zu einer entsprechenden Verringerung der maximalen Arbeitstemperatur. Insgesamt weisen die aus dem Stand der Technik gemäß den Druckschriften US 6,765,335 B1 oder US 7,218,031 B2 bekannten Ultraschallmotoren einen vergleichsweise geringen Wirkungsgrad auf.

Es ist daher Aufgabe der Erfindung, einen Ultraschallmotor bereitzustellen, der die Nachteile der Ultraschallmotoren gemäß dem zuvor genannten Stand der Technik überwindet, und insbesondere einen Ultraschallmotor mit hoher Effektivität bzw. einem hohen Wirkungsgrad bereitzustellen.

Die Lösung der Aufgabe der Erfindung erfolgt durch einen Ultraschallmotor gemäß Patentanspruch 1, wobei die daran anschließenden Unteransprüche mindestens zweckmäßige Ausgestaltungen und Weiterbildungen umfassen.

Es wird demnach von einem Ultraschallmotor ausgegangen, der einen Ultraschallaktor in Form eines piezoelektrischen Hohlzylinders mit einer inneren Umfangsfläche und einer äußeren Umfangsfläche und die innere und äußere Umfangsfläche miteinander verbindende Stirnflächen umfasst, wobei an wenigstens einer Stirnfläche Friktionselemente angeordnet sind. Weiterhin umfasst der Ultraschallmotor einen mit den Friktionselementen in Wirkkontakt stehenden Rotor aufweisend wenigstens eine Scheibe oder eine Plattform, sowie eine elektrische Erregervorrichtung.

Der Ultraschallaktor ist entlang seines Umfangs bzw. in Umfangsrichtung in eine gerade Zahl von Sektoren Sa und Sb unterteilt, wobei jeder Sektor durch dessen geometrische Abmessungen L, Hund T charakterisiert ist. Hierbei bezeichnet L die mittlere Länge des Sektors, und zwar in Umfangsrichtung des Hohlzylinders in der Mitte zwischen Außenumfang und Innenumfang. H bezeichnet die Höhe des Sektors in Richtung der Längs- oder Rotationsachse des Hohlzylinders (Axialrichtung), und T bezeichnet die Dicke des Sektors, also den Abstand zwischen Innen- und Außenumfangsfläche in radialer Richtung. Die mittlere Länge List demnach die Länge des Sektors in Umfangsrichtung bei der halben Dicke T, d.h. bei T/2. Alle Sektoren Sa bilden zusammen die Sektorengruppe A, während alle Sektoren Sb zusammen die Sektorengruppe B bilden. An jeden Sektor Sa grenzen an in Umfangsrichtung gesehen gegenüberliegenden Seiten zwei Sektoren Sb an, und an jeden Sektor Sb grenzen in gleicher Weise zwei Sektoren Sa an, so dass sich in Umfangsrichtung die Sektoren Sa und Sb der beiden Sektorengruppen A und B abwechseln und aneinander angrenzen. Im Bereich der Grenzfläche zwischen zwei benachbarten Sektoren Sa und Sb, d.h. im Bereich der Angrenzung benachbarter Sektoren, sind die Friktionselemente angeordnet.

Erfindungswesentlich ist, dass jeder der Sektoren Sa und Sb durch in Axialrichtung des Hohlzylinders abwechselnd angeordnete Erregerelektroden und allgemeine Elektroden gebildet ist, wobei jeweils zwischen benachbarten Erregerelektroden und allgemeinen Elektroden eine Schicht piezoelektrischen Materials angeordnet ist, und alle Erregerelektroden der die Sektorengruppe A bildenden Sektoren Sa miteinander, alle Erregerelektroden der die Sektorengruppe B bildenden Sektoren Sb miteinander und alle allgemeinen Elektroden des Ultraschallaktors miteinander elektrisch verbunden sind.

Durch eine an die Erregerelektroden und die allgemeinen Elektroden über die elektrische Erregervorrichtung angelegte elektrische Spannung bildet sich zwischen ihnen das elektrische Feld E aus, wobei der Vektor des elektrischen Feldes E mit der Richtung der Längs- oder Rotationsachse des Ultraschallaktors zusammenfällt. Durch den umgekehrten piezoelektrischen Effekt erzeugt das elektrische Feld E in Richtung der Längs- oder Rotationsachse die Kraft Fad und in tangentialer Richtung die Kraft Ftd.

Die Kraft Fad besteht aus der statischen Anpresskraft Fas, wodurch die Kraft Fa entsteht, die das Friktionselement an den Rotor anpresst. Die Kraft Fa wirkt der Elastizitätskraft Fs des Friktionskontaktes entgegen. Die Kraft Ftd veranlasst den Rotor, sich entgegen der Kraft Fr zu bewegen.

Im Einklang mit der Theorie ist die piezoelektrische Kraft Fad proportional zum Piezomodul d33 und die Kraft Ftd proportional zum Piezomodul d31.

Bei harter PZT Keramik liegt das Verhältnis von d33/d31 im Bereich zwischen 2,5 und 3. Das bedeutet, dass der Aktor 1 des erfindungsgemäßen Ultraschallmotors eine in axialer Richtung (d.h. längs zur bzw. entlang der Längs- oder Rotationsachse) wirkende dynamische Kraft Fad entwickelt, die 2,5 bis 3 Mal größer als die in tangentialer Richtung entwickelte Kraft Ftd ist.

Aus der Bedingung für eine optimale Funktion des Friktionskontaktes, nach der die statische Anpresskraft Fas gleich der Amplitude der dynamischen Kraft Fad sein muss, folgt, dass in diesem Fall die gesamte Anpresskraft Fa gleich der doppelten Amplitude der dynamischen Anpresskraft Fad sein muss. Das bedeutet, dass bei Einhaltung dieser Bedingung im vorgeschlagenen Motor die Anpresskraft Fa gleich 5 - 6 Ftd ist. D. h. beim Anlegen einer elektrischen Spannung an die Erregerelektroden und allgemeinen Elektroden entsteht im Friktionskontakt des erfindungsgemäßen Ultraschallmotors die Anpresskraft Fa, die 5 bis 6 Mal größer als die Amplitude der Tangentialkraft Ftd ist.

Entsprechend den obigen Darlegungen zeichnet sich der Friktionskontakt des erfindungsgemäßen Ultraschallmotors durch eine 2,5 bis 3 mal größere Reibungskraft Ffk im Friktionskontakt aus, als dies bei den Motoren nach dem Stand der Technik gemäß der eingangs erwähnten Druckschriften US 6,765,335 B2 und US 7,218,031 B2 der Fall ist. Das ermöglicht es ihm, bedeutend größere maximale Kräfte als im Vergleich zu den Ultraschallmotoren nach US 6,765,335 B2 oder US 7,218,031 B2 zu entwickeln, und ein Schlupf innerhalb des Friktionskontaktes bei hohen Zugkräften wird deutlich reduziert bzw. sogar vermieden. Insgesamt resultiert ein Ultraschallmotor mit hoher Zugkraft bei gleichzeitig niedrigen Verlusten und damit einer niedrigen Eigenerwärmung.

Im Folgenden werden die Begriffe "Hohlzylinder" und "Zylinder", bzw. "Ultraschallaktor" und "Aktor", bzw. "Ultraschallmotor" und "Motor" synonym verwendet.

Es kann von Vorteil sein, dass die Erregerelektroden und die allgemeinen Elektroden und die jeweils zwischen benachbarten Erregerelektroden und allgemeinen Elektroden angeordneten Schichten piezoelektrischen Materials der Sektoren einer Sektorengruppe einen Generator für akustische Longitudinalstehwellen bilden, und die so gebildeten Generatoren derart elektrisch ansteuerbar sind, dass sich eine erste Longitudinalstehwelle längs der Erzeugenden des Ultraschallaktors und sich eine zweite akustische Longitudinalstehwelle längs der Höhe des Ultraschallaktors ausbreitet. Die Ausbreitung längs der Erzeugenden des Ultraschallaktors ist hier und auch im Folgenden so zu verstehen, dass sich die Longitudinalstehwelle in Umfangsrichtung ausbreitet.

Daneben kann es von Vorteil sein, dass die Erregerelektroden und die allgemeinen Elektroden und die jeweils zwischen benachbarten Erregerelektroden und allgemeinen Elektroden angeordneten Schichten piezoelektrischen Materials der Sektoren einer Sektorengruppe einen Generator für eine akustische asymmetrische Stehwelle bilden, und die so gebildeten Generatoren derart elektrisch ansteuerbar sind, dass sich die akustischen asymmetrischen Stehwellen längs der Erzeugenden des Ultraschallaktors ausbreitet.

Weiterhin kann es von Vorteil sein, dass das Verhältnis L zu H zwischen 1 und 1,3 ist, und dass das Verhältnis H zu T zwischen 2 und 20 ist. Hierdurch resultiert ein besonders effektiv betreibbarer Ultraschallmotor.

Es kann ebenso von Vorteil sein, dass der Rotor Dämpfungselemente umfasst, welche die Amplitude parasitärer Schwingungen des Rotors verringern.

Außerdem kann es von Vorteil sein, dass die elektrische Erregervorrichtung eine elektrische Einphasenerregerspannung bereitstellt, und die elektrische Erregervorrichtung einen Umschalter zum Anlegen der Einphasenerregerspannung an die Erregerelektroden und die allgemeinen Elektroden entweder der ersten oder der zweiten Sektorengruppe zur Umkehr der Drehrichtung des Rotors umfasst.

Darüber hinaus kann es von Vorteil sein, dass die elektrische Erregervorrichtung eine elektrische Zweiphasenspannung bereitstellt, wobei eine der so bereitgestellten Spannungen U1 und U2 an die Erregerelektroden und die allgemeinen Elektroden einer Sektorengruppe angelegt ist, und die zweite der so bereitgestellten Spannungen an die Erregerelektroden und die allgemeinen Elektroden der anderen Sektorengruppe angelegt ist, und die elektrische Erregervorrichtung einen Umschalter zur Phasenverschiebung zwischen den bereitgestellten Spannungen U1 und U2 zur Umkehr der Drehrichtung des Rotors aufweist.

Zudem kann es von Vorteil sein, dass parallel zu den Erregerelektroden und den allgemeinen Elektroden einer Sektorengruppe oder parallel zu den Erregerelektroden und den allgemeinen Elektroden beider Sektorengruppen Kompensationsinduktivitäten Lk geschaltet sind, die teilweise oder vollständig die kapazitive Komponente des Stroms der Elektroden einer Sektorengruppe oder beider Sektorengruppen kompensieren.

Es kann auch von Vorteil sein, dass die elektrische Erregervorrichtung ein Rückkopplungselement aufweist, das in Reihe mit den Elektroden einer der Sektorengruppen geschaltet ist.

Hierbei kann es insbesondere von Vorteil sein, dass die elektrische Erregervorrichtung einen Rückkopplungskreis zur Frequenzregelung der Erregerspannung nach dem Phasensignal des Rückkopplungselements aufweist.

Zusätzlich kann es von Vorteil sein, dass der Ultraschallmotor einen Lageoder Geschwindigkeitsgeber des Rotors und einen Regler für Lage und Geschwindigkeit des Rotors aufweist.

Weitere vorteilhafte Weiterbildungen des Ultraschallmotors ergeben sich durch Kombinationen der in den Ansprüchen, in der Beschreibung und in den Zeichnungen offenbarten Merkmale. Kurze Beschreibung der Zeichnungen
Fig.1: Explosionsdarstellung eines erfindungsgemäßen Ultraschallmotors
Fig.2: Darstellung 17: dreidimensionale Ansicht eines Ultraschallaktors eines erfindungsgemäßen Ultraschallmotors; Darstellung 18: Draufsicht des Ultraschallaktors gemäß Darstellung 17
Fig.3: Darstellung 19: Dreidimensionale Ansicht eines Abschnitts eines Ultraschallaktors eines erfindungsgemäßen Ultraschallmotors mit Friktionselementen an einer der Stirnflächen; Darstellung 20: dreidimensionale Ansicht eines Abschnitts eines Ultraschallaktors eines erfindungsgemäßen Ultraschallmotors mit Friktionselementen an beiden Stirnflächen

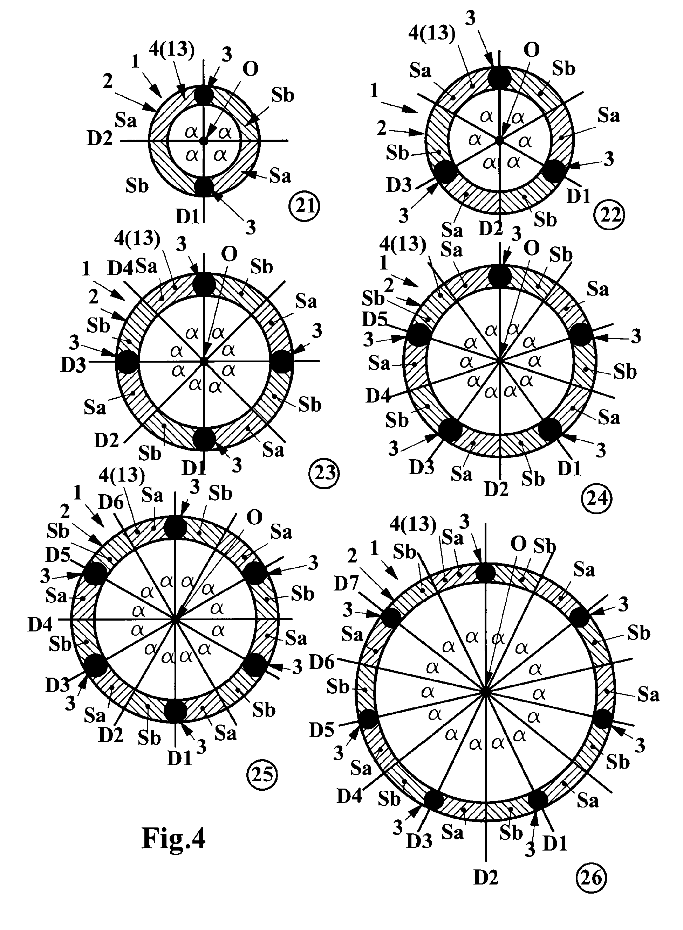

Fig.4: Darstellungen 21 bis 26: Draufsichten auf Ultraschallaktoren eines erfindungsgemäßen Ultraschallmotors mit unterschiedlicher Anzahl an daran angeordneten Friktionselementen
Fig.5: Darstellung 27: Innerer Aufbau eines Sektors eines Ultraschallaktors eines erfindungsgemäßen Ultraschallmotors in dreidimensionaler Ansicht; Darstellung 28: innerer Aufbau des Sektors gemäß Darstellung 27 in Seitenansicht und mit Darstellung der elektrischen Verbindungen
Fig.6: Darstellung 40: Dreidimensionale Ansicht eines Ultraschallaktors eines erfindungsgemäßen Ultraschallmotors; Darstellung 41: Draufsicht auf eine Schicht von als Kreisringsegmente ausgeführte Erregerelektroden des Ultraschallaktors gemäß Darstellung 40; Darstellung 42: Explosionsdarstellung des Ultraschallaktors gemäß Darstellung 40
Fig.7: Darstellung 43: Dreidimensionale Ansicht eines Ultraschallaktors eines erfindungsgemäßen Ultraschallmotors; Darstellung 46: Draufsicht auf eine Schicht von Erregerelektroden des Ultraschallaktors gemäß Darstellung 43; Darstellung 47: Explosionsdarstellung des Ultraschallaktors gemäß Darstellung 43
Fig.8: Darstellung einer Ausführungsform der elektrischen Kontaktierung der Elektroden eines Ultraschallaktors eines erfindungsgemäßen Ultraschallmotors in Form eines abgewickelten Mantelflächenabschnitts des Ultraschallaktors
Fig.9: Darstellung einer weiteren Ausführungsform der elektrischen Kontaktierung der Elektroden eines Ultraschallaktors eines erfindungsgemäßen Ultraschallmotors in Form eines abgewickelten Mantelflächenabschnitts des Ultraschallaktors
Fig.10: Darstellungen 49 und 50: Unterschiedliche Ausführungsformen einer Schaltung zum Verbinden der Erregerelektroden und der allgemeinen Elektroden der Sektoren Sa und Sb eines Ultraschallaktors mit einer elektrischen Erregervorrichtung des erfindungsgemäßen Ultraschallmotors; Darstellungen 55 bis 57: Unterschiedliche mögliche Bewegungsbahnen eines Punktes eines Friktionselements eines erfindungsgemäßen Ultraschallmotors
Fig.11: Darstellungen 59 bis 62: vier Phasen maximaler Deformation eines unbelasteten Ultraschallaktors eines erfindungsgemäßen Ultraschallmotors mit bestimmten Abmessungen im Fall seiner einphasigen Erregung und einer bestimmten Frequenz der Erregerspannung
Fig.12: Darstellungen 63 und 64: Eingriffs- bzw. Kontaktverhältnisse zwischen Friktionselement und Rotor zu unterschiedlichen Zeitpunkten; Darstellung 65: Verdeutlichung der zwischen Friktionselement und Rotor wirkenden Kräfte gemäß Eingriffsverhältnis nach Darstellung 64
Fig.13: Explosionsdarstellung eines erfindungsgemäßen Ultraschallmotors
Fig.14: Weitere Ausführungsform eines erfindungsgemäßen Ultraschallmotors
Fig.15: Blockschaltbild einer einphasigen elektrischen Erregervorrichtung des erfindungsgemäßen Ultraschallmotors
Fig.16: Blockschaltbild einer zweiphasigen elektrischen Erregervorrichtung des erfindungsgemäßen Ultraschallmotors
Fig.17: Blockschaltbild betreffend einen erfindungsgemäßen Ultraschallmotor mit einem Lageoder Geschwindigkeitsgeber des Rotors und einem Regler für Lage und Geschwindigkeit des Rotors

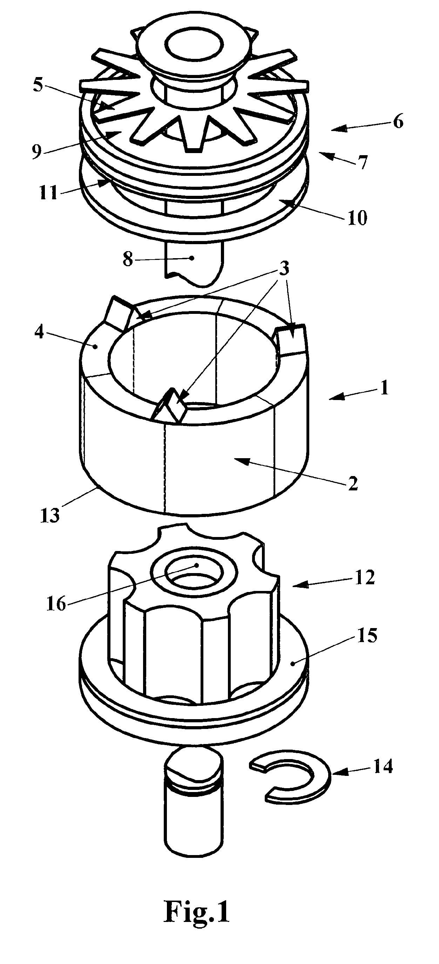

Fig. 1 verdeutlicht anhand einer Explosionsdarstellung den Aufbau einer möglichen Ausführungsform des erfindungsgemäßen Ultraschallmotors.

Dieser weist einen als piezoelektrischen Hohlzylinder 2 ausgeführten Ultraschallaktor 1 auf. An einer der Stirnflächen 4 des Ultraschallaktors sind drei Friktionselemente 3 in zueinander gleichem umfänglichem Abstand angeordnet. Der Rotor 6 wird mit Hilfe einer Feder 5 gegen die Friktionselemente 3 gedrückt, wobei der Rotor als mehrteilige, mit der Achse 8 verbundene Scheibe 7 ausgeführt ist.

Die mehrteilige Scheibe 7 umfasst die Halterung 9, die Friktionsschiene 10 und das zwischen der Halterung 9 und der Friktionsschiene 10 befindliche Dämpfungselement 11. Das Dämpfungselement 11 ist als elastischer Kleber ausgeführt. Daneben ist denkbar, das Dämpfungselement beispielsweise als Gummiring oder als mit festen Teilchen angereicherte viskose Schicht auszuführen. Die Friktionsschiene 10 besteht aus einer Oxidkeramik auf Basis von AI20 ₃ mit Zr02 als Zusatz. Andere Oxidkeramiken oder andere harte abriebfeste Werkstoffe wie Nicht-Oxid-Keramiken, z.B. Siliciumcarbid, Borcarbid, Siliciumnitrid, Aluminiumnitrid, Bornitrid usw., sind hierfür ebenso denkbar.

Der Ultraschallaktor 1 ist in der Halterung 12 angeordnet. Mit seiner zweiten Stirnfläche 13, an der keine Friktionselemente angeordnet sind, stützt sich der Aktor 1 auf der schallisolierenden Unterlage 15 ab. Die Halterung 12 weist ein Kugellager 16 auf, in dem sich die Achse 8 dreht. Der Rotor 6 wird durch das Halteelement 14 gehalten.

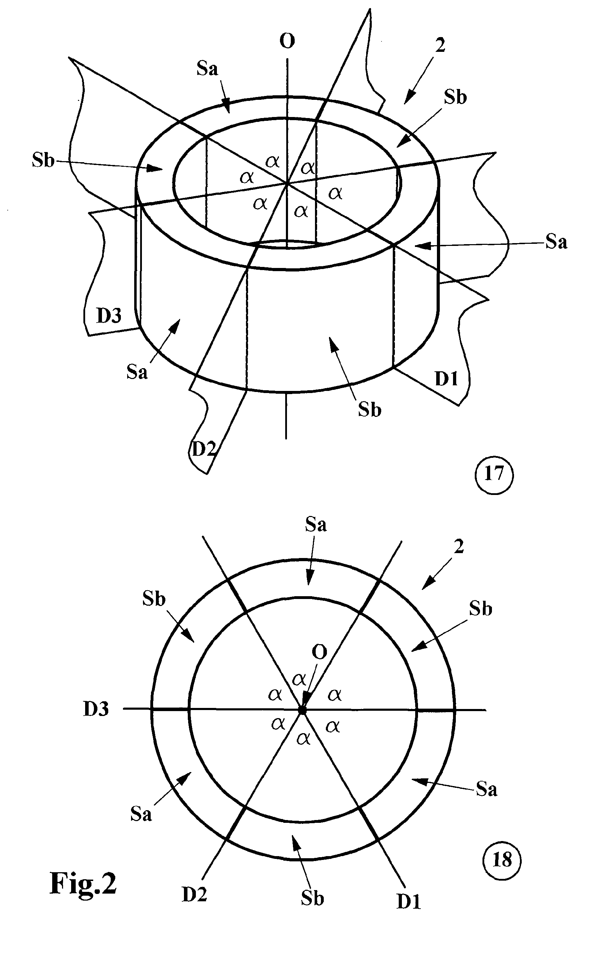

Gemäß Fig. 2 lässt sich der piezoelektrische Zylinder 2 durch axial-diametrale Ebenen - hier beispielsweise durch die drei axial-diametralen Ebenen 01, 02 und 03 - in eine gerade Zahl gleicher Sektoren (Hohlzylindersegmente) Sa und Sb unterteilen, wobei alle Sektoren Sa eine Sektorengruppe A und alle Sektoren Sb eine Sektorengruppe B bilden. Die Sektoren Sa und die Sektoren Sb sind abwechselnd entlang des Umfangs des hohlzylindrischen Ultraschallaktors angeordnet und grenzen jeweils aneinander.

Die axial-diametralen Ebenen 01, 02 und 03 werden durch die Längsoder Rotationsachse O des Zylinders 2 und einen seiner Parameter gebildet. Unter dem Begriff Gleichheit der Sektoren Sa und Sb wird verstanden, dass die axial-diametralen Ebenen 01, 02 und 03 den Zylinder 2 in die Sektoren Sa und Sn mit den gleichen Umfangswinkeln α teilt.

Die Zahl der den Zylinder 2 des Aktors 1 teilenden axial-diametralen Ebenen kann beliebig sein, z.B. n.

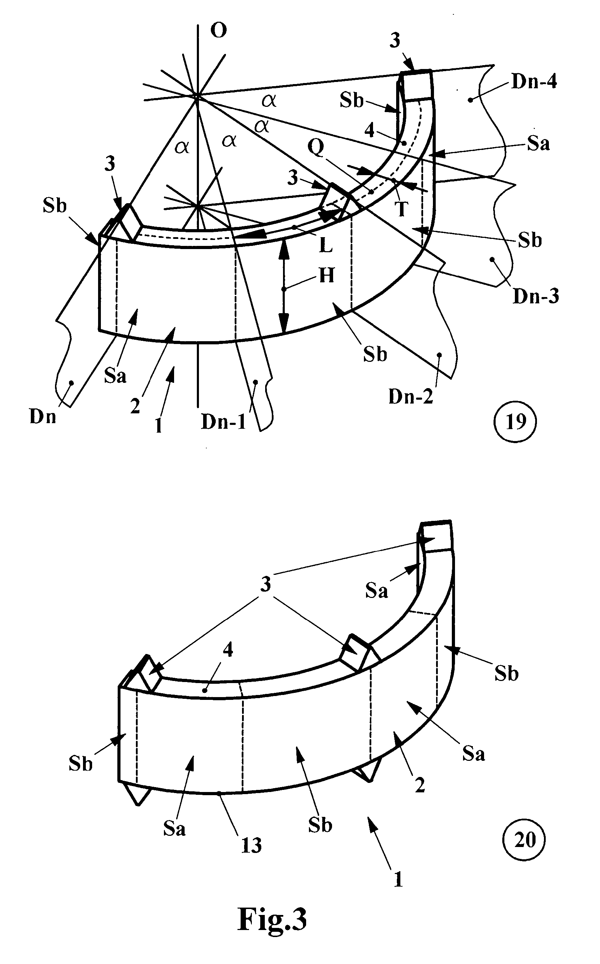

Darstellung 19 von Fig. 3 zeigt einen Teil des hohlzylindrischen Ultraschallaktors 1, wobei dieser in n axial-diametrale Ebenen unterteilt ist. Der (Umfangs-)Winkel α der Sektoren Sa und Sb für einen solchen Ultraschallaktor ist gleich 360/2n=180/n.

Im Ultraschallaktor 1 des erfindungsgemäßen Ultraschallmotors weist der piezoelektrische Hohlzylinder 2 die Erzeugende Q auf. Weitere geometrische Größen des hohlzylindrischen Ultraschallaktors bzw. seiner Sektoren Sa bzw. Sb sind: die mittlere Länge L des Sektors Sa oder Sb, die Höhe H in Richtung der Längs- oder Rotationsachse O und die Wanddicke T in radialer Richtung. Die mittlere Länge L ist hierbei die Länge des Sektors in Umfangsrichtung bei der Position T/2. Die Länge der Erzeugenden Q ist daher die Summe der Längen L aller Sektoren Sa und Sb, d.h. Q=nL.

Die Friktionselemente 3 sind auf der Stirnfläche 4 des Zylinders 2 jeweils im Bereich der Grenze zweier angrenzender Sektoren Sa und Sb (Sektoren paar) angeordnet, und zwar symmetrisch bezüglich dem durch die jeweilige axial-diametrale Ebene D geteilten Sektoren paar.

Gemäß Darstellung 20 von Fig. 3 können die Friktionselemente 3 auch auf beiden Stirnflächen 4 des Ultraschallaktors 2 angeordnet sein.

In den Darstellungen 21 bis 26 sind Ultraschallaktoren in Draufsicht gezeigt, welche zwei, drei, vier, fünf, sechs und sieben Friktionselemente 3 aufweisen. Die Friktionselemente sind hierbei aus der Oxidkeramik Al₂0₃ gefertigt können jedoch auch aus anderen harten und abriebfesten Werkstoffen sein, beispielsweise aus der Oxidkeramik Zr0₂ oder aus einer Nicht-Oxidkeramik wie SIC oder Si₃N₄. Sie können jedoch auch aus festen Monokristallen wie z. B. aus Saphir, Rubin, Korund gefertigt sein. Des Weiteren können sie auch aus Metallkeramik auf der Basis von Wolframkarbid, Titankarbid u. ä. gefertigt sein. Zudem können die Friktionselemente auch aus verschiedenartigen harten Polymerwerkstoffen hergestellt sein, und dabei mit harten abriebfesten Teilchen wie z. B. Aluminiumoxid, Zirkoniumoxid, Wolframkarbid, Titankarbid u. ä. gefüllt sein.

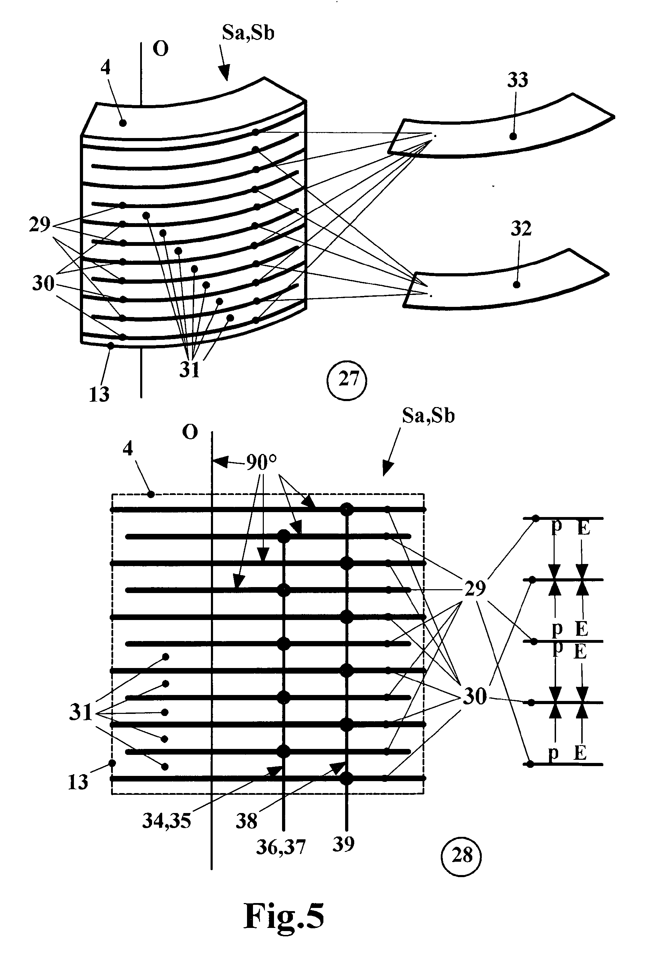

Gemäß Fig. 5 weist jeder Sektor Sa bzw. Sb jeder Sektorengruppe A und B in axialer Richtung abwechselnd angeordnete Schichten von Erregerelektroden 29 und allgemeinen Elektroden 30 auf, wobei jeweils zwischen benachbarten Erregerelektroden 29 und allgemeinen Elektroden 30 eine Piezokeramikschicht 31 angeordnet ist.

Die Schichten der Erregerelektroden 29 sind hierbei als Segmente 32, und die Schichten allgemeiner Elektroden 30 sind als Segmente 33 ausgeführt.

Die Schichten der Elektroden 29, 30 sind als dünne Palladiumschichten mit Dicken zwischen 10 und 150 Mikrometer ausgeführt. Es ist jedoch ebenso denkbar, die Schichten der Elektroden 29, 30 als dünne Palladium-Silberschichten oder als dünne Kupferschichten auszuführen. Die Piezokeramikschichten 31 weisen eine harte PZT-Piezokeramik mit einer Dicke zwischen 30 und 50 Mikrometer auf. Die Herstellung des Ultraschallaktors erfolgt hierbei mittels piezokeramischer Multilayer-Technologien, jedoch ist auch eine Herstellung durch Synthese von Piezokeramik in der Luft oder im Schutzgas möglich.

In jedem Sektor Sa und Sb sind die Schichten 29, 30, 31 normal, d.h. unter einem Winkel von 90°, zur Längs- oder Rotationsachse 0 des Zylinders 2 angeordnet und damit parallel zu den Stirnflächen 4,13 des Zylinders.

Die Piezokeramikschichten 31 sind zu den Elektroden 29, 30 normal polarisiert (in Darstellung 28 von Fig. 5 durch Pfeile mit dem Index p gekennzeichnet). Bei einer solchen Polarisation ist der Polarisationsvektor p parallel zur Längs- oder Rotationsachse des Zylinders 2 und senkrecht zu seinen Stirnflächen 4, 13 gerichtet.

Alle den Sektoren Sa der Sektorengruppe A zugehörigen Schichten von Erregerelektroden 29 sind elektrisch miteinander verbunden. Ebenso sind alle Schichten der Erregerelektroden 29 der Sektorengruppe B elektrisch miteinander verbunden. Darüber hinaus sind alle Schichten der allgemeinen Elektroden 30 der Sektoren Sa und der Sektoren Sb der Sektorengruppen A und B elektrisch miteinander verbunden.

Hierbei sind in jedem Sektor Sa und Sb alle Schichten der Erregerelektroden 29 untereinander mit Hilfe der leitenden Bahnen 34 und 35 und mit den Anschlüssen 36 und 37 verbunden, und alle Schichten der allgemeinen Elektroden 30 sind untereinander mit Hilfe der leitenden Bahnen 38 mit den Anschlüssen 39 verbunden.

Bei dieser Art der Verbindung der Elektroden sind folgende zwei Grenzfälle denkbar:
Im ersten Fall bilden die Erregerelektroden 29 zusammen mit den allgemeinen Elektroden 30 und den Piezokeramikschichten 31 zwischen ihnen aller zur Sektorengruppe A gehörenden Sektoren Sa den ersten kombinierten Generator für eine sich entlang der Erzeugenden Q des piezoelektrischen Zylinders 2 des Ultraschallaktors 1 ausbreitende akustische Longitudinalstehwelle (d.h. eine sich in Umfangsrichtung ausbreitende akustische Longitudinalstehwelle) und für eine sich entlang der Höhe H bzw. der Höhenerstreckung des piezoelektrischen Zylinders 2 des Ultraschallaktors 1 ausbreitende akustische Longitudinalstehwelle. Die Erregerelektroden 29 zusammen mit den allgemeinen Elektroden 30 und den Piezokeramikschichten 31 zwischen ihnen aller zur Sektorengruppe B gehörenden Sektoren Sb bilden den zweiten kombinierten Generator für eine sich entlang der Erzeugenden Q des piezoelektrischen Zylinders 2 des Ultraschallaktors 1 bzw. eine sich in Umfangsrichtung ausbreitende akustische Longitudinalstehwelle und für eine sich entlang der Höhe H des piezoelektrischen Zylinders 2 des Ultraschallaktors 1 bzw. eine sich in Höhenrichtung ausbreitende akustische Longitudinalstehwelle.

Im zweiten Fall bilden die Erregerelektroden 29 zusammen mit den allgemeinen Elektroden 30 und den Piezokeramikschichten 31 zwischen ihnen aller zur Sektorengruppe A gehörenden Sektoren Sa den ersten Generator für eine sich entlang der Erzeugenden Q des piezoelektrischen Zylinders 2 des Ultraschallaktors 1 ausbreitende asymmetrische akustische Longitudinalstehwelle. Die Erregerelektroden 29 bilden zusammen mit den allgemeinen Elektroden 30 und den Piezokeramikschichten 31 zwischen ihnen aller zur Sektorengruppe B gehörenden Sektoren Sb den zweiten Generator für eine sich entlang der Erzeugenden Q des piezoelektrischen Zylinders 2 des Ultraschallaktors 1 ausbreitende asymmetrische akustische Longitudinalstehwelle.

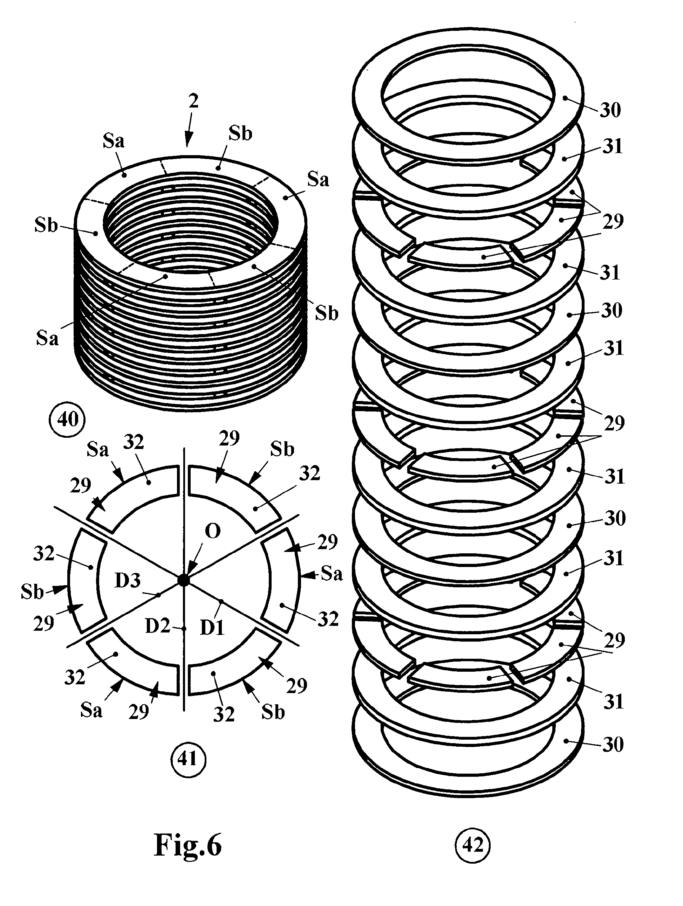

Gemäß Darstellung 41 von Fig. 6 sind die Erregerelektroden 29 des hohlzylindrischen Ultraschallaktors nach Darstellung 40 von Fig. 6 als Segmente 32 und die allgemeinen Elektroden 30 gemäß Darstellung 42 als Ringe ausgeführt, die alle Sektoren Sa und Sb beider Sektorengruppen A und B kreuzen.

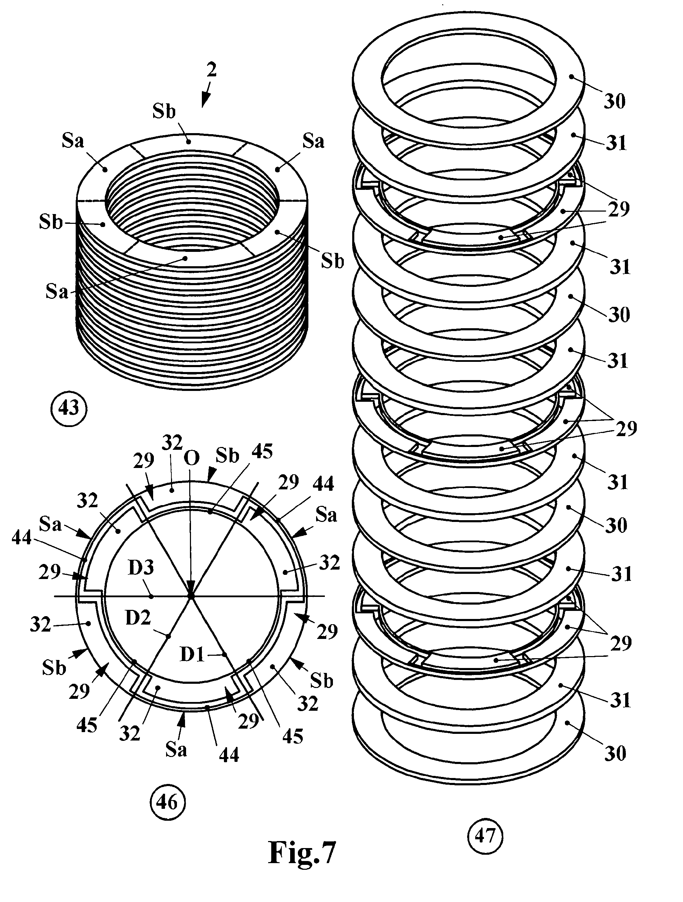

Gemäß Darstellung 46 von Fig. 7 sind die Erregerelektroden 29 des hohlzylindrischen Ultraschallaktors gemäß Darstellung 43 als Segmente 32 ausgeführt, die mit den elektrisch leitenden Bahnen 44 und 45 verbunden sind. Die Bahnen 44 verbinden die Elektroden 29 der Sektoren Sa miteinander, während die Bahnen 45 die Elektroden 29 der Sektoren Sb miteinander verbinden.

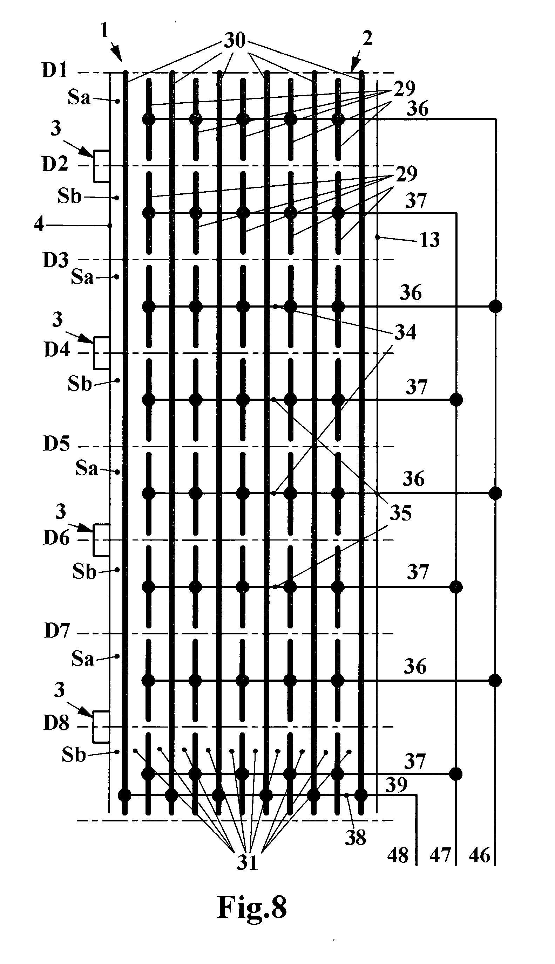

Nach Fig. 8, in welcher schematisch ein Teil der abgewickelten Mantelfläche eines Ultraschallaktors eines erfindungsgemäßen Ultraschallmotors mit den Elektroden 29, 30 auf ihm gezeigt ist, sind alle Erregerelektroden 29 der Sektoren Sa der Sektorengruppe A mit den leitenden Bahnen 34 über die Anschlüsse 36 mit dem Ausgang 46 der Elektroden der Sektorengruppe A verbunden, während alle Erregerelektroden 29 der Sektoren Sb der Sektorengruppe B mit den leitenden Bahnen 35 über die Anschlüssen 37 mit dem Ausgang 47 der Elektroden der Sektorengruppe B verbunden sind. Alle allgemeinen Elektroden 30 sind mit den elektrisch leitenden Bahnen 38 über den Anschluss 39 mit dem Ausgang 48 der Sektorengruppen A und B verbunden.

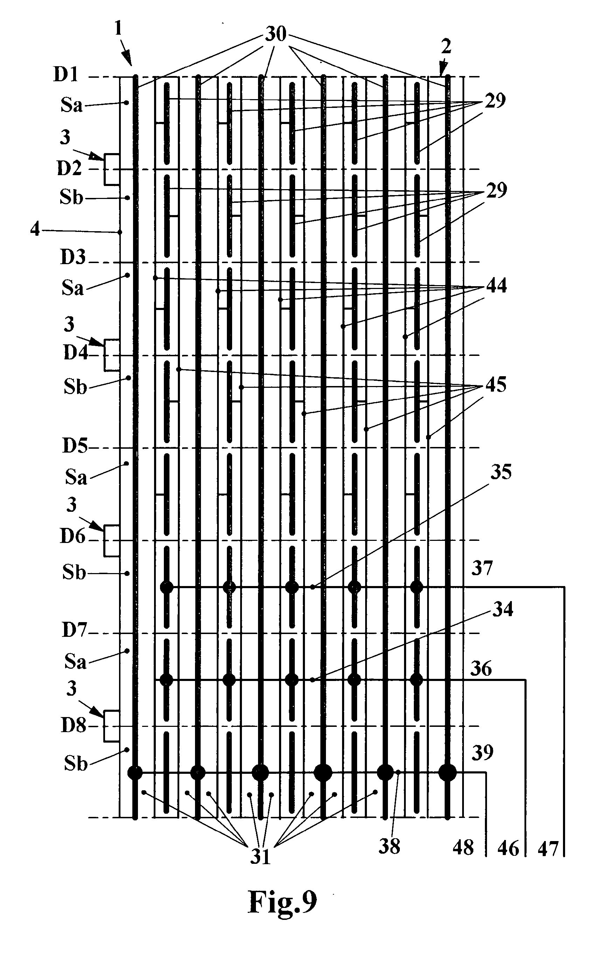

Nach Fig. 9, in welcher schematisch ein Teil der abgewickelten Mantelfläche einer weiteren Ausführungsform eines Ultraschallaktors eines erfindungsgemäßen Ultraschallmotors mit den Elektroden 29, 30 auf ihm gezeigt ist, sind alle Erregerelektroden 29 der Sektoren Sa der Sektorengruppen A mit den leitenden Bahnen 34 über die Anschlüsse 36 mit dem Ausgang 46 der Elektroden der Sektorengruppe A verbunden. Alle Erregerelektroden 29 der Sektoren Sb der Sektorengruppe B sind mit den leitenden Bahnen 45 über die Anschlüssen 37 mit dem Ausgang 47 der Sektorengruppe B verbunden, und alle allgemeinen Elektroden 30 sind mit den elektrisch leitenden Bahnen 38 über den Anschluss 38 mit dem Ausgang 48 der Sektorengruppen A und B verbunden.

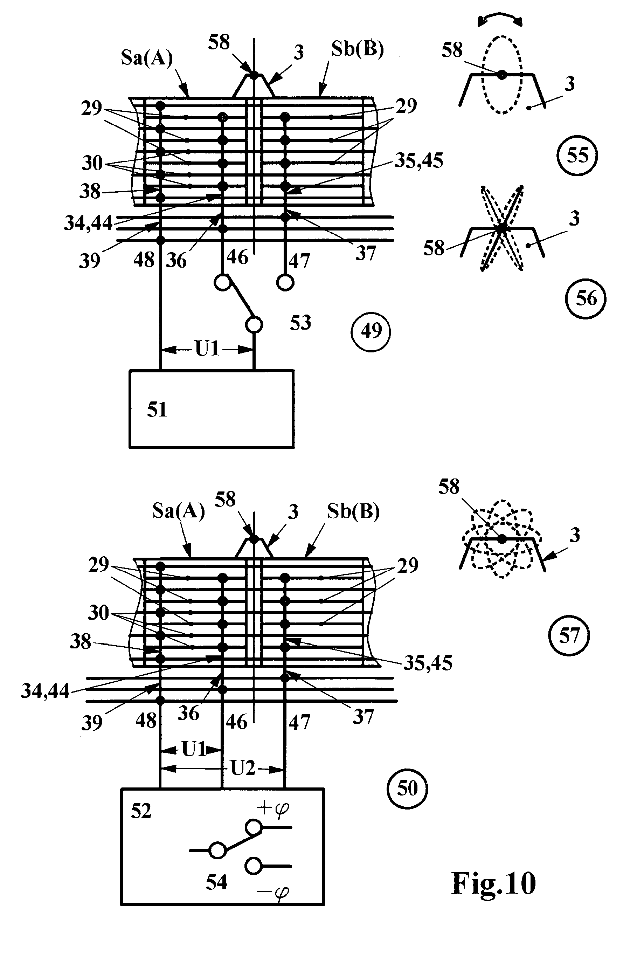

Die Darstellungen 49 und 50 von Fig. 10 zeigen unterschiedliche Schaltungsvarianten zum Verbinden der Erregerelektroden 29 und der allgemeinen Elektroden 30 der Sektoren Sa und Sb mit der elektrischen Erregervorrichtung 51 bzw. 52.

Die elektrische Erregervorrichtung 51 stellt hierbei eine einphasige elektrische Spannung U1 bereit. Diese Spannung wird mit Hilfe des Umschalters 53 an die Elektroden 29 und 30 aller Sektoren Sa der Sektorengruppe A oder an die Elektroden 29 und 30 der Sektoren Sb der Sektorengruppe B gelegt.

] Die elektrische Erregervorrichtung 52 stellt dagegen eine zweiphasige elektrische Spannung U1, U2 mit einer Phasenverschiebung Φ zwischen den Spannungen U1, U2 bereit. Die Spannung U1 wird an die Elektroden 29, 30 aller Sektoren Sa der Sektorengruppe A gelegt. Die Spannung U2 wird an die Elektroden 29, 30 aller Sektoren Sb der Sektorengruppe B gelegt.

Die elektrische Erregervorrichtung 52 weist einen Phasenumschalter 54 auf, mit dem die Phasenverschiebung von Plus Φ auf Minus Φ geändert werden kann.

Die Spannungen U1, U2 können eine sinusförmige, eine dreieckige, eine sägezahnförmige, eine rechteckige Form oder eine beliebige andere Form aufweisen, bei der die Frequenz f0 der ersten Harmonischen dieser Spannungen der Frequenz der akustischen Longitudinalstehwelle entspricht, die sich entlang der Erzeugenden Q des piezoelektrischen Zylinders 2 des Aktors 1 ausbreitet, und die Frequenz f0 der akustischen Longitudinalstehwelle entspricht, die sich entlang der Höhe H des piezoelektrischen Zylinders 2 des Aktors 1 ausbreitet.

Außerdem kann die Frequenz f0 der Frequenz der akustischen asymmetrischen Longitudinalstehwelle entsprechen, die sich entlang der Erzeugenden Q des piezoelektrischen Zylinders des Rotors 1 ausbreitet.

Beim Anlegen der Erregerspannung U1 an die Erregerelektroden 29 und an die allgemeinen Elektroden 30 der Sektoren Sa und Sb wird der erste oder der zweite Generator für akustische Wellen erregt. Mit dem Umschalter 53 können die Generatoren umgeschaltet werden.

Für die Funktion des Aktors 1 sind zwei Grenzfälle denkbar. Diese Prinzipien werden im Folgenden für freie Schwingungen des Aktors 1 betrachtet:
Im ersten Fall erzeugt die Spannung U1 gleichzeitig im Aktor 1 zwei symmetrische akustische Wellen, nämlich eine akustische Longitudinalstehwelle, die sich längs der Erzeugenden Q des piezoelektrischen Zylinders 2 ausbreitet, und eine akustische Longitudinalstehwelle, die sich längs der Höhe H des piezoelektrischen Zylinders 2 ausbreitet. In diesem Fall arbeiten der erste und der zweite Generator wie kombinierte Generatoren für zwei Typen von akustischen Wellen.

Durch die Überlagerung der zwei Typen von akustischen Wellen bewegen sich die auf den Friktionsoberflächen der Friktionselemente 3 angeordneten Punkte 58 auf der gemäß Darstellung 55 von Fig. 10 durch die punktierte Linie gezeigten elliptischen Bewegungsbahn. Beim Betätigen des Umschalters 53 kehrt sich die Bewegungsrichtung der Punkte 58 um. Das ändert die Bewegungsrichtung des Rotors 6.

Im zweiten Fall erzeugt die Spannung U1 im Aktor 1 eine asymmetrische akustische Welle, die sich längs der Erzeugenden Q des piezoelektrischen Zylinders 2 ausbreitet. Durch die Ausbreitung dieser Welle bewegen sich die auf den Friktionsoberflächen der Friktionselemente 3 angeordneten Punkte 58 auf der gemäß Darstellung 56 von Fig. 10 durch die punktierte Linie gezeigten geneigten linearen Bewegungsbahn oder auf einer gedehnten elliptischen Bewegungsbahn. Beim Betätigen des Umschalters 53 kehrt sich die Neigung der Bewegungsbahn zur Friktionsoberfläche des Friktionselementes 3 um.

Die Auswahl des einen oder des anderen Funktionsprinzips kann durch die Wahl des entsprechenden Verhältnisses von L/H oder der entsprechenden Frequenz f0 erfolgen.

Bei einer Zweiphasenerregung des Aktors 1 werden an die Erregerelektroden 29 und die allgemeinen Elektroden 30 der Sektoren Sa und Sb gleichzeitig die zwei Erregerspannungen U1 und U2 angelegt. Dabei werden gleichzeitig der erste und der zweite Generator für die akustischen Wellen erregt. Diese Art der Erregung macht eine beliebige Form und eine beliebige Neigung der elliptischen Bewegungsbahn der Punkte 58 möglich, verdeutlicht durch die punktierte Linie in Darstellung 57 von Fig. 10. Die Änderung der Form und der Neigung der Bewegungsbahn kann durch Änderung der Amplitude der Spannungen U1, U2 und des Phasenverschiebungswinkels Φ bewirkt werden. Durch das Betätigen des Umschalters 54 ist es möglich, den Phasenverschiebungswinkel von Plus Φ auf Minus Φ zu ändern. Dadurch ändert sich die Drehrichtung des Rotors 6.

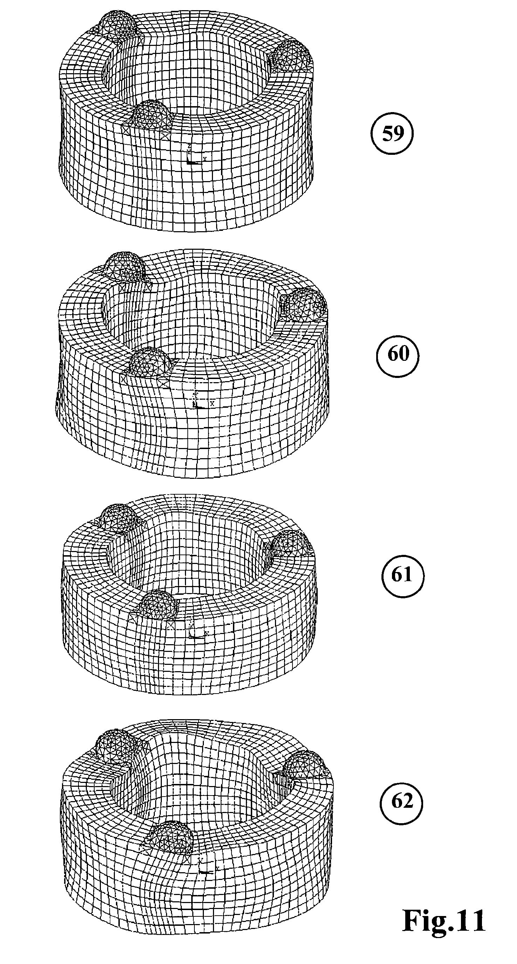

Die Darstellungen 59 bis 62 von Fig. 11 zeigen vier Phasen maximaler Deformation des unbelasteten Aktors 1 in Form eines Hohlzylinders mit den Abmessungen ø14 x ø 10 x 6 mm im Fall seiner einphasigen Erregung und der Frequenz der Erregerspannung von f0= 289,2 kHz.

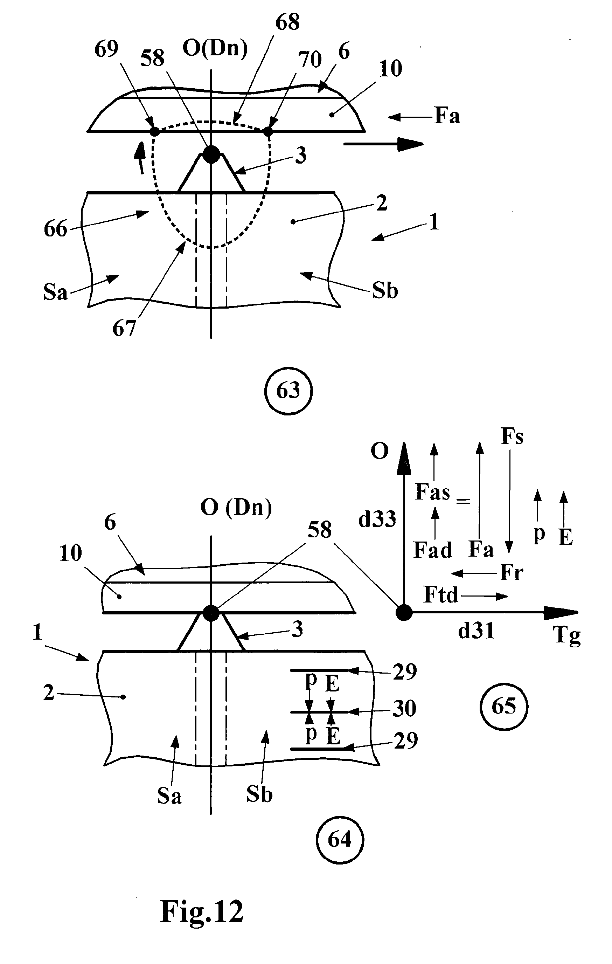

Die Darstellungen 63 bis 65 von Fig.12 dienen der Erläuterung des Funktionsprinzips des Friktionskontaktes für einen erfindungsgemäßen Ultraschallmotor bei maximaler auf das Friktionselement 3 von Seiten des Rotors 6 einwirkender Last Fr. Beim Betrieb mit maximaler Last wird davon ausgegangen, dass der Rotor 6 mit der Kraft Fr gebremst wird und sich mit einer Geschwindigkeit bedeutend kleiner als seine Maximalgeschwindigkeit bewegt, wobei zwischen Friktionselement 3 und Friktionsschiene im Friktionskontakt noch kein Schlupf auftritt.

Bei diesem Funktionsprinzip bewegen sich die Punkte 58 auf der Friktionsoberfläche des Friktionselementes 3 auf der Bewegungsbahn 66 gemäß Darstellung 63 von Fig. 12.

Die Bewegungsbahn 66 weist zwei zwischen den Punkten 69 und 70 liegende charakteristische Abschnitte 67 und 68 auf. Im Abschnitt 67 tangiert das Friktionselement 3 nicht die Friktionsschiene 10, d.h. der Aktor 1 ist ohne Last. Im Abschnitt 68 wird das Friktionselement 3 an die Friktionsschiene 10 angepresst. Der Aktor 1 wird über den Rotor 6 mit der Kraft Fr beaufschlagt.

Darstellung 64 von Fig. 12 verdeutlicht die Bewegung des Friktionselements 3 im Abschnitt 68.

Darstellung 65 von Fig. 12 zeigt die im Friktionskontakt des Motors bei Bewegung des Friktionselementes 3 im Abschnitt 68 der Bewegungsbahn 66 einwirkenden Kräfte.

Durch die an die Elektroden 29 und 30 angelegten elektrischen Spannungen U1 oder U2 bildet sich zwischen ihnen das elektrische Feld E aus. Die Darstellungen 64 und 65 von Fig. 12 zeigen den Vektor des elektrischen Feldes E, dessen Richtung mit der des Polarisationsvektors p und der Richtung der Längs- oder Rotationsachse zusammenfällt.

Durch den umgekehrten piezoelektrischen Effekt erzeugt das elektrische Feld E in Richtung der Längs- oder Rotationsachse die Kraft Fad und in Richtung der Tangentialachse Tg die Kraft Ftd. Im Abschnitt 68 der Bewegungsbahn 66 sind diese Kräfte maximal.

Die Kraft Fad besteht aus der statischen Kraft Fas, wodurch die Kraft Fa entsteht, die das Friktionselement 3 an die Friktionsschiene 10 anpresst. Die Kraft Fa wirkt der Elastizitätskraft des Friktionskontaktes Fs entgegen. Die Kraft Ftd veranlasst den Rotor 6 sich entgegen der Kraft Fr zu bewegen.

Die piezoelektrische Kraft Fad ist dabei proportional zum Piezomodul d33 und die Kraft Ftd proportional zum Piezomodul d31.

Bei harter PZT Keramik liegt das Verhältnis von d33/d31 im Bereich zwischen 2,5 und 3. Das bedeutet, dass der Aktor 1 des erfindungsgemäßen Ultraschallmotors eine in axialer Richtung (d.h. längs bzw. entlang der Längs- oder Rotationsachse) wirkende dynamische Kraft Fad entwickelt, die 2,5 bis 3 mal größer als die in tangentialer Richtung (längs zur Achse Tg) entwickelte Kraft Ftd.

Aus der Bedingung für eine optimale Funktion des Friktionskontaktes, nach der die statische Anpresskraft Fas gleich der Amplitude der dynamischen Kraft Fad sein muss, folgt, dass in diesem Fall die gesamte Anpresskraft Fa gleich der doppelten Amplitude der dynamischen Anpresskraft Fad sein muss. Das bedeutet, dass bei Einhaltung dieser Bedingung im vorgeschlagenen Motor die Anpresskraft Fa gleich 5 - 6 Ftd ist. D. h. beim Anlegen der elektrischen Spannung an die Elektroden 29 und 30 entsteht im Friktionskontakt des erfindungsgemäßen Ultraschallmotors die Anpresskraft Fa, die 5 bis 6 Mal größer als die Amplitude der Tangentialkraft Ftd ist.

Entsprechend den obigen Darlegungen zeichnet sich der Friktionskontakt des erfindungsgemäßen Ultraschallmotors durch eine 2,5 bis 3 mal größere Reibungskraft Ffk im Friktionskontakt aus, als dies bei den Motoren nach dem Stand der Technik gemäß der eingangs erwähnten Druckschriften US 6,765,335 B2 und US 7,218,031 B2 der Fall ist. Das ermöglicht es ihm, bedeutend größere maximale Kräfte als im Vergleich zu den Ultraschallmotoren nach US 6,765,335 B2 oder US 7,218,031 B2 zu entwickeln.

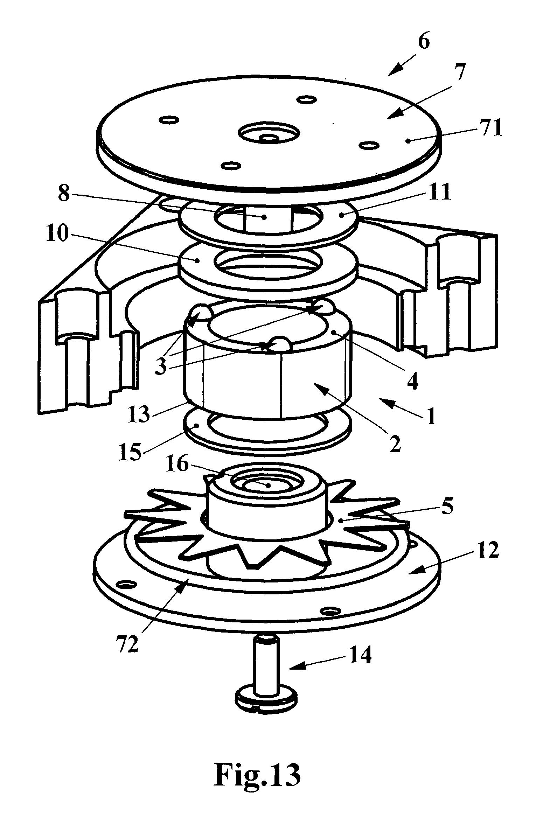

Fig. 13 zeigt einen als Arbeitstisch ausgeführten Ultraschallmotor. Der Rotor 6 dieses Motors besteht aus der Plattform 71, die fest auf der Achse 8 montiert ist. Auf der Plattform 71 ist mit dem Dämpfungselement 11 die Friktionsschiene 10 befestigt. Die Feder 5 presst die Friktionselemente 3 des Ultraschallaktors 1 an die Friktionsschiene 10 an; dies erfolgt über die schallisolierende Unterlage 15 und die Stirnfläche 13 des piezoelektrischen Rings 2, abgestützt auf den Anschlagring 72.

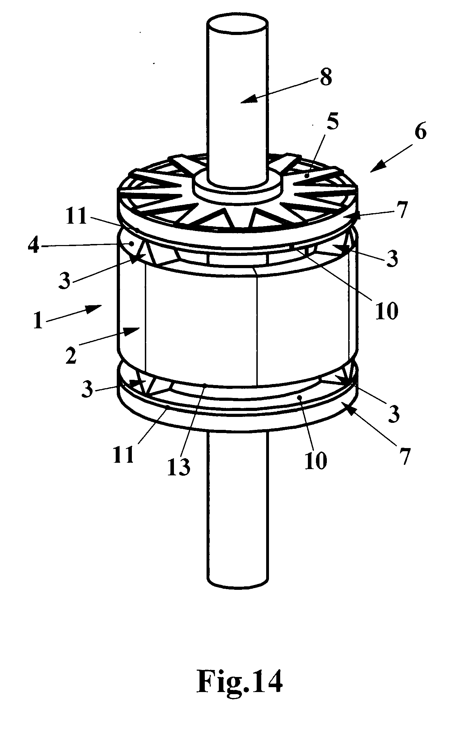

Fig. 14 zeigt eine Ausführungsform des erfindungsgemäßen Ultraschallmotors, bei dem der Rotor 6 zwei zusammengesetzte Scheiben 7 aufweist.

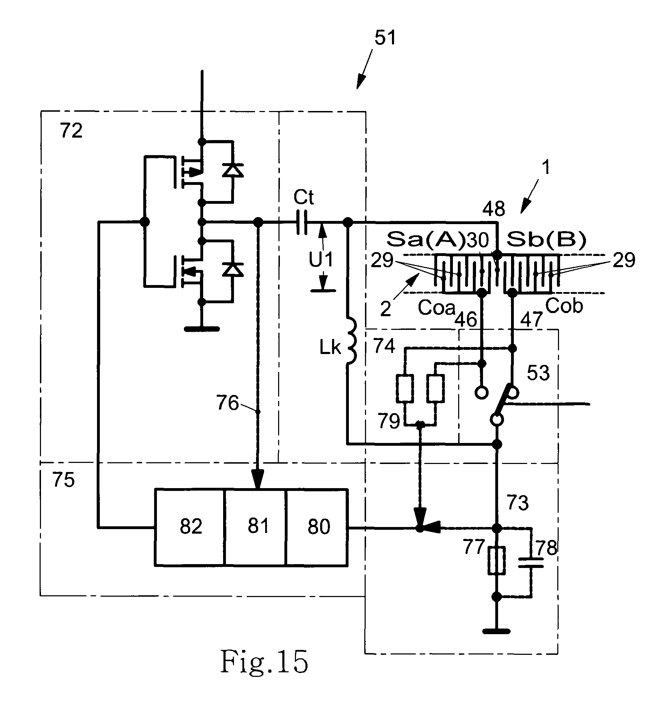

Die Fig. 15 zeigt eine vereinfachte elektrische Schaltung der einphasigen elektrischen Erregervorrichtung 51. Die Schaltung besteht aus dem Leistungsverstärker 72, dem Rückkopplungselement 73 oder 74, dem Rückkopplungskreis 75, der Phasenkette 76, der Kompensationsspule mit der Induktivität Lk und dem Trennkondensator mit der Kapazität Ct.

Der Leistungsverstärker 72 kann ein Linearverstärker oder ein Impulshalbbrückenverstärker sein, ausgeführt mit bipolaren Transistoren oder mit Feldeffekttransistoren. Als Rückkopplungselement 73 kann der niederohmige Widerstand 77 mit ggf. parallel geschaltetem Kondensator 78 verwendet werden. Als weiteres Element des Rückkopplungskreises 74 kann ein Spannungsteiler 79 verwendet werden, der mit den Erregerelektroden 29 der Sektoren Sa und Sb verbunden ist.

Der Rückkopplungskreis kann ein Filter 80, einen Phasendetektor 81 und einen Steuergenerator 82 enthalten. Diese Glieder können sowohl als diskrete Elemente, als auch als programmierbarer Mikroprozessor ausgeführt sein.

Parallel zu den Elektroden 29, 30 des Aktors 1 kann eine Kompensationsspule mit der Induktivität Lk geschaltet sein. Die Größe der Induktivität der Kompensationsspule wird aus der Bedingung 2πf0Lk=1 /2πf0Co bestimmt. Dabei wird der Wert für Ct so gewählt, dass er bedeutend größer als der für Co ist.

Durch den Einsatz der Kompensationsspule mit der Induktivität Lk ist es möglich, teilweise oder vollständig die die kapazitive Komponente des Stroms der Elektroden einer Sektorengruppe oder der zwei Sektorengruppen zu kompensieren.

Die in Fig. 15 dargestellte Schaltung funktioniert wie ein Frequenzregler f0 für die Erregerspannung U1 des Aktors 1 nach dem Phasensignal des Elements des Rückkopplungskreises 73 oder 74.

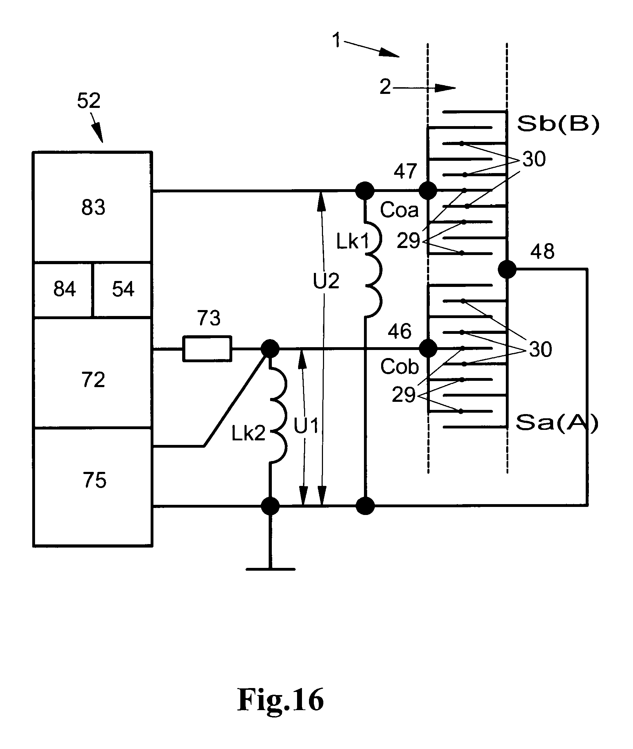

Die Fig. 16 zeigt eine vereinfachte elektrische Schaltung der zweiphasigen elektrischen Erregervorrichtung 52. Die Schaltung besitzt einen als Analogverstärker ausgeführten zusätzlichen Leistungsverstärker 83. Der Verstärker 83 ist über den Phasenschieber 84 und den Phasenumschalter 54 mit dem Verstärker 72 verbunden.

Bei einer Zweiphasenerregung des Aktors 1 können zwei Kompensationsspulen mit den Induktivitäten Lka und Lkb verwendet werden, die parallel zu den Elektroden 29 und 30 der Sektoren Sa und Sb der Sektorengruppen A und B geschaltet werden.

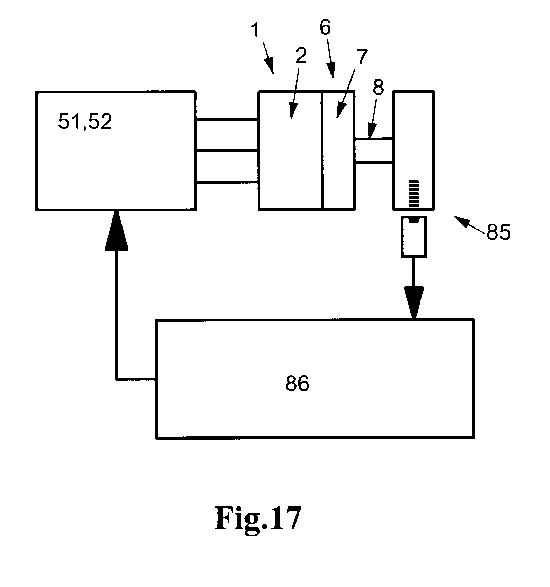

Gemäß Fig. 17 kann der erfindungsgemäße Ultraschallmotor mit einem Lage- oder einem Geschwindigkeitsgeber 85 des Rotors 6 und einem Regler für Lage und Geschwindigkeit 86 des Rotors 6 ausgestattet sein.

## Patentansprüche

1. Ultraschallmotor, umfassend einen Ultraschallaktor (1) in Form eines piezoelektrischen Hohlzylinders (2) mit einer inneren Umfangsfläche und einer äußeren Umfangsfläche und die innere und äußere Umfangsfläche miteinander verbindende Stirnflächen (4), wobei an wenigstens einer Stirnfläche (4) Friktionselemente (3) angeordnet sind, einen mit den Friktionselementen (3) in Wirkkontakt stehenden Rotor (6) aufweisend wenigstens eine Scheibe oder eine Plattform (7), und eine elektrische Erregervorrichtung (51, 52), wobei der Ultraschallaktor (1) in Umfangsrichtung in eine gerade Zahl von Sektoren Sa und Sb mit einer mittleren Länge L eines Sektors in Umfangsrichtung, mit einer Höhe H eines Sektors in Axialrichtung und einer Dicke T eines Sektors in radialer Richtung unterteilt ist, und die Sektoren eine erste Sektorengruppe A und eine zweite Sektorengruppe B bilden, wobei sich in Umfangsrichtung die Sektoren Sa und Sb der beiden Sektorengruppen A und B abwechseln und aneinander angrenzen, und im Bereich der Angrenzung benachbarter Sektoren die Friktionselemente (3) angeordnet sind, **dadurch gekennzeichnet, dass** jeder der Sektoren Sa und Sb gebildet ist durch in Axialrichtung des Hohlzylinders abwechselnd angeordnete Erregerelektroden (29) und allgemeine Elektroden (30), wobei jeweils zwischen benachbarten Erregerelektroden (29) und allgemeinen Elektroden (30) eine Schicht piezoelektrischen Materials (31) angeordnet ist, und wobei alle Erregerelektroden (29) der die Sektorengruppe A bildenden Sektoren Sa miteinander, alle Erregerelektroden (29) der die Sektorengruppe B bildenden Sektoren Sb miteinander und alle allgemeinen Elektroden (30) des Ultraschallaktors (1) miteinander elektrisch verbunden sind.

2. Ultraschallmotor nach Anspruch 1, **dadurch gekennzeichnet, dass** die Erregerelektroden (29) und die allgemeinen Elektroden (30) und die jeweils zwischen benachbarten Erregerelektroden (29) und allgemeinen Elektroden (30) angeordneten Schichten piezoelektrischen Materials (31) der Sektoren einer Sektorengruppe einen Generator für akustische Longitudinalstehwellen bilden, und die so gebildeten Generatoren derart elektrisch ansteuerbar sind, dass sich eine erste Longitudinalstehwelle längs der Umfangsrichtung des Ultraschallaktors (1) und sich eine zweite akustische Longitudinalstehwelle längs der Höhe des Ultraschallaktors (1) ausbreitet.

3. Ultraschallmotor nach Anspruch 1, **dadurch gekennzeichnet, dass** die Erregerelektroden (29) und die allgemeinen Elektroden (30) und die jeweils zwischen benachbarten Erregerelektroden (29) und allgemeinen Elektroden (30) angeordneten Schichten piezoelektrischen Materials (31) der Sektoren einer Sektorengruppe einen Generator für eine akustische asymmetrische Stehwelle bilden, und die so gebildeten Generatoren derart elektrisch ansteuerbar sind, dass sich die akustischen asymmetrischen Stehwellen längs der Umfangsrichtung des Ultraschallaktors (1) ausbreitet.

4. Ultraschallmotor nach einem der vorhergehenden Ansprüche, **dadurch gekennzeichnet, dass** das Verhältnis L zu H zwischen 1 und 1,3 ist, und dass das Verhältnis H zu T zwischen 2 und 20 ist.

5. Ultraschallmotor nach einem der vorhergehenden Ansprüche, **dadurch gekennzeichnet, dass** der Rotor (6) Dämpfungselemente (11) umfasst, welche die Amplitude parasitärer Schwingungen des Rotors (6) verringern.

6. Ultraschallmotor nach einem der vorhergehenden Ansprüche, **dadurch gekennzeichnet, dass** die elektrische Erregervorrichtung (51) eine elektrische Einphasenerregerspannung bereitstellt, und die elektrische Erregervorrichtung (51) einen Umschalter (53) zum Anlegen der Einphasenerregerspannung an die Erregerelektroden (29) und die allgemeinen Elektroden (30) entweder der ersten oder der zweiten Sektorengruppe zur Umkehr der Drehrichtung des Rotors (6) umfasst.

7. Ultraschallmotor nach einem der vorhergehenden Ansprüche 1 bis 5, **dadurch gekennzeichnet, dass** die elektrische Erregervorrichtung (52) eine elektrische Zweiphasenspannung bereitstellt, wobei eine der so bereitgestellten Spannungen U1 und U2 an die Erregerelektroden (29) und die allgemeinen Elektroden (30) einer Sektorengruppe angelegt ist, und die zweite der so bereitgestellten Spannungen an die Erregerelektroden (29) und die allgenmeinen Elektroden der anderen Sektorengruppe angelegt ist, und die elektrische Erregervorrichtung (52) einen Umschalter (54) zur Phasenverschiebung zwischen den bereitgestellten Spannungen U1 und U2 zur Umkehr der Drehrichtung des Rotors (6) aufweist.

8. Ultraschallmotor nach einem der vorhergehenden Ansprüche, **dadurch gekennzeichnet, dass** parallel zu den Erregerelektroden (29) und den allgemeinen Elektroden (30) einer Sektorengruppe oder parallel zu den Erregerelektroden (29) und den allgemeinen Elektroden (30) beider Sektorengruppen Kompensationsspulen mit einer Induktivität Lk geschaltet sind, die teilweise oder vollständig die kapazitive Komponente des Stroms der Elektroden einer Sektorengruppe oder beider Sektorengruppen kompensieren.

9. Ultraschallmotor nach einem der vorhergehenden Ansprüche, **dadurch gekennzeichnet, dass** die elektrische Erregervorrichtung (51, 52) ein Rückkopplungselement (73,74) aufweist, das in Reihe mit den Elektroden einer der Sektorengruppen geschaltet ist.

10. Ultraschallmotor nach Anspruch 9, **dadurch gekennzeichnet, dass** die elektrische Erregervorrichtung (51, 52) einen Rückkopplungskreis (75) zur Frequenzregelung der Erregerspannung nach dem Phasensignal des Rückkopplungselements aufweist.

11. Ultraschallmotor nach einem der vorhergehenden Ansprüche, **dadurch gekennzeichnet, dass** dieser einen Lage- oder Geschwindigkeitsgeber (85) des Rotors (6) und einen Regler (86) für Lage und Geschwindigkeit des Rotors (6) aufweist.

## Claims

1. Ultrasonic motor, comprising an ultrasonic actuator (1) in the form of a piezoelectric hollow cylinder (2) with an inner peripheral surface, and an outer peripheral surface, and end faces (4) which connect the inner and the outer peripheral surfaces to each other, wherein friction elements (3) are disposed on at least one end face (4), a rotor (6) being in functional contact with the friction elements (3), the rotor (6) comprising at least one disc or one platform (7), and an electrical excitation device (51, 52), wherein the ultrasonic actuator is divided in peripheral direction in an even number of sectors Sa an Sb having a middle length L of a sector in peripheral direction, having a height H of a sector in axial direction, and a thickness T of a sector in radial direction, and the sectors form a first sector-group A and a second sector-group B, wherein in peripheral direction the sectors Sa and Sb of both groups of sectors A and B alter and border each other, and the friction elements (3) are disposed in the border area of neighbored sectors, **characterized in that** each of the sectors Sa and Sb is formed by excitation electrodes (29) and general electrodes (30) being alternately arranged in axial direction of the hollow cylinder, wherein between neighbored excitation electrodes (29) and general electrodes (30) a layer of piezoelectric material (31) is disposed, and wherein all excitation electrodes (29) of the sectors Sa forming the sector-group A are electrically connected with each other, all excitation electrodes (29) of the sectors Sb forming the sector-group B are electrically connected with each other, and all general electrodes (30) of the ultrasonic actuator (1) are electrically connected with each other.

2. Ultrasonic motor according to claim 1, **characterized in that** the excitation electrodes (29), and the general electrodes (30), and the layers of piezoelectric material (31) being disposed between neighbored excitation electrodes (29) and general electrodes (30), respectively, of the sectors of a sector-group form a generator for acoustic longitudinal standing waves, and the so formed generators are electrically controllable such that a first longitudinal standing wave expands along the peripheral direction of the ultrasonic actuator (1) and a second acoustic longitudinal standing wave expands along the height of the ultrasonic actuator (1).

3. Ultrasonic motor according to claim 1, **characterized in that** the excitation electrodes (29), and the general electrodes (30), and the layers of piezoelectric material (31) being disposed between neighbored excitation electrodes (29) and general electrodes (30), respectively, of the sectors of a sector-group form a generator for an acoustic asymmetric standing wave, and the so formed generators are electrically controllable such that the acoustic asymmetric standing waves expand along the peripheral direction of the ultrasonic actuator (1).

4. Ultrasonic motor according to one of the preceding claims, **characterized in that** the ratio L to H lies between 1 and 1,3, and that the ratio H to T lies between 2 and 20.

5. Ultrasonic motor according to one of the preceding claims, **characterized in that** the rotor (6) comprises damping elements (11) which lower the amplitude of parasitic oscillations of the rotor (6).

6. Ultrasonic motor according to one of the preceding claims, **characterized in that** the electrical excitation device (51) provides an electrical one-phase excitation voltage, and the electrical excitation device (51) comprises a switch (53) for applying a one-phase excitation voltage to the excitation electrodes (29) and the general electrodes (30) of either the first or the second sector-group for reversing the sense of rotation of the rotor (6).

7. Ultrasonic motor according to one of claims 1 to 5, **characterized in that** the electrical excitation device (52) provides an electrical two-phase voltage, wherein one of the so provided voltages U1 and U2 is applied to the excitation electrodes (29) and the general electrodes (30) of a sector-group, and the second of the so provided voltages is applied to the excitation electrodes (29) and the general electrodes of the other sector-group, and the excitation device (52) comprises a switch (54) for shifting the phase between the provided voltages U1 and U2 for reversing the sense of rotation of the rotor (6).

8. Ultrasonic motor according to one of the preceding claims, **characterized in that** compensation coils with an inductivity Lk are connected parallel to the excitation electrodes (29) and the general electrodes (30) of one sector-group or parallel to the excitation electrodes (29) and the general electrodes (30) of both groups of sectors, which compensation coils partially or completely compensate the capacitive component of the current of the electrodes of one sector-group or of both groups of sectors.

9. Ultrasonic motor according to one of the preceding claims, **characterized in that** the electrical excitation device (51, 52) comprises a feedback element (73, 74) which is connected in series with the electrodes of one of the groups of sectors.

10. Ultrasonic motor according to claim 9, **characterized in that** the electrical excitation device (51, 52) comprises a feedback circuit (75) for frequency regulation of the excitation voltage according to the phase signal of the feedback element.

11. Ultrasonic motor according to one of the preceding claims, **characterized in that** aforesaid comprises a position or a velocity transmitter (85) of the rotor (6) and a controller (86) for the position and the velocity of the rotor (6).

## Revendications

1. Moteur à ultrasons, comprenant un actionneur à ultrasons (1) sous la forme d'un cylindre creux piézoélectrique (2) avec une surface périphérique intérieure et une surface périphérique extérieure et des surfaces frontales (4) reliant ensemble la surface périphérique intérieure et la surface périphérique extérieure, dans lequel des éléments de friction (3) sont disposés sur au moins une surface frontale (4), un rotor (6) en contact fonctionnel avec les éléments de friction (3) et présentant au moins un disque ou une plateforme (7), et un dispositif d'excitation électrique (51, 52), dans lequel l'actionneur à ultrasons (1) est subdivisé en direction périphérique en un nombre pair de secteurs Sa et Sb avec une longueur moyenne L d'un secteur en direction périphérique, avec une hauteur H d'un secteur en direction axiale et une épaisseur T d'un secteur en direction radiale, et les secteurs formant un premier groupe de secteurs A et un deuxième groupe de secteurs B, dans lequel les secteurs Sa et Sb des deux groupes de secteurs A et B alternent en direction périphérique et sont contigus les uns aux autres, et les éléments de friction (3) étant disposés dans la zone de contiguïté de secteurs voisins, **caractérisé en ce que** chacun des secteurs Sa et Sb est formé par des électrodes d'excitation (29) et des électrodes générales (30) disposées en alternance dans la direction axiale du cylindre creux, dans lequel une couche de matériau piézoélectrique (31) est respectivement disposée entre des électrodes d'excitation (29) et des électrodes générales (30) voisines, et dans lequel toutes les électrodes d'excitation (29) des secteurs Sa formant le groupe de secteurs A sont reliées électriquement les unes aux autres, toutes les électrodes excitatrices (29) des secteurs Sb formant le groupe de secteurs B sont reliées électriquement les unes aux autres et toutes les électrodes générales (30) de l'actionneur à ultrasons (1) sont reliées électriquement les unes aux autres.

2. Moteur à ultrasons selon la revendication 1, **caractérisé en ce que** les électrodes d'excitation (29) et les électrodes générales (30) et les couches de matériau piézoélectrique (31), respectivement disposées entre des électrodes d'excitation (29) et des électrodes générales (30) voisines, des secteurs d'un groupe de secteurs forment un générateur pour des ondes stationnaires longitudinales acoustiques, et les générateurs ainsi formés pouvant être commandés électriquement de manière à ce qu'une première onde stationnaire longitudinale se propage le long de la direction périphérique de l'actionneur à ultrasons (1) et qu'une deuxième onde stationnaire longitudinale acoustique se propage le long de la hauteur de l'actionneur à ultrasons (1).

3. Moteur à ultrasons selon la revendication 1, **caractérisé en ce que** les électrodes d'excitation (29) et les électrodes générales (30) et les couches de matériau piézoélectrique (31), respectivement disposées entre des électrodes d'excitation (29) et des électrodes générales (30) voisines, des secteurs d'un groupe de secteurs forment un générateur pour une onde stationnaire acoustique asymétrique, et les générateurs ainsi formés pouvant être commandés électriquement de manière à ce que les ondes stationnaires acoustiques asymétriques se propagent le long de la direction périphérique de l'actionneur à ultrasons (1).

4. Moteur à ultrasons selon l'une des revendications précédentes, **caractérisé en ce que** le rapport entre L et H est compris entre 1 et 1,3, et **en ce que** le rapport entre H et T est compris entre 2 et 20.

5. Moteur à ultrasons selon l'une des revendications précédentes, **caractérisé en ce que** le rotor (6) comprend des éléments d'atténuation (11) qui réduisent l'amplitude d'oscillations parasites du rotor (6).

6. Moteur à ultrasons selon l'une des revendications précédentes, **caractérisé en ce que** le dispositif d'excitation électrique (51) met à disposition une tension d'excitation monophasée, et le dispositif d'excitation électrique (51) comprenant un commutateur inverseur (53) pour l'application de la tension d'excitation monophasée aux électrodes d'excitation (29) et aux électrodes générales (30) du premier groupe de secteurs ou du deuxième groupe de secteurs pour inverser le sens de rotation du rotor (6).

7. Moteur à ultrasons selon l'une des revendications 1 à 5 précédentes, **caractérisé en ce que** le dispositif d'excitation électrique (52) met à disposition une tension biphasée électrique, dans lequel l'une des tensions U1 et U2 ainsi mises à disposition est appliquée aux électrodes d'excitation (29) et aux électrodes générales (30) d'un groupe de secteurs, et la deuxième des tensions ainsi mises à disposition étant appliquée aux électrodes d'excitation (29) et aux électrodes générales de l'autre groupe de secteurs, et le dispositif d'excitation électrique (52) présentant un commutateur inverseur (54) pour le décalage de phase entre les tensions U1 et U2 mises à disposition pour l'inversion du sens de rotation du rotor (6).

8. Moteur à ultrasons selon l'une des revendications précédentes, **caractérisé en ce que**, parallèlement aux électrodes d'excitation (29) et aux électrodes générales (30) d'un groupe de secteurs ou parallèlement aux électrodes d'excitation (29) et aux électrodes générales (30) des deux groupes de secteurs, des bobines de compensation sont couplées avec une inductance Lk, lesquelles compensent partiellement ou complètement la composante capacitive du courant des électrodes d'un groupe de secteurs ou des deux groupes de secteurs.

9. Moteur à ultrasons selon l'une des revendications précédentes, **caractérisé en ce que** le dispositif d'excitation électrique (51, 52) présente un élément de rétroaction (73, 74) qui est couplé en série avec les électrodes de l'un des groupes de secteurs.

10. Moteur à ultrasons selon la revendication 9, **caractérisé en ce que** le dispositif d'excitation électrique (51, 52) présente un circuit de rétroaction (75) pour la régulation de fréquence de la tension d'excitation après le signal de phase de l'élément de rétroaction.

11. Moteur à ultrasons selon l'une des revendications précédentes, **caractérisé en ce que** celui-ci présente un transmetteur de position ou de vitesse (85) du rotor (6) et un régulateur (86) pour la position et la vitesse du rotor (6).
